# EUROPÄISCHE PATENTSCHRIFT

(11) **EP 3 533 236 B1**
(45) Veröffentlichungstag und Bekanntmachung des Hinweises auf die Patenterteilung: **19.08.2020**
(21) Anmeldenummer: 17788144.8
(22) Anmeldetag: 09.10.2017
(51) Int. Cl.: H04Q 9/00, H05K 7/14

(54) **VERTEILERLEISTE**
DISTRIBUTOR BLOCK
BARRETTE DE DISTRIBUTION

(30) Priorität: 26.10.2016 DE 102016120412
(43) Veröffentlichungstag der Anmeldung: 04.09.2019
(73) Patentinhaber: Vertiv Integrated Systems GmbH, 94424 Arnstorf (DE)
(72) Erfinder: HOFBAUER, Thomas, 94113 Tiefenbach (DE); HUBER, Arthur, 94081 Fürstenzell (DE); FEIGL, Josef, 94424 Arnstorf (DE)
(74) Vertreter: Wunderlich & Heim Patentanwälte Partnerschaftsgesellschaft mbB
(86) Internationale Anmeldenummer: PCT/EP2017/075613
(87) Internationale Veröffentlichungsnummer: WO 2018/077596

(56) Entgegenhaltungen:
- US-B1- 7 522 036
- US-B1- 8 639 459

## Beschreibung

Die Erfindung betrifft eine Verteilerleiste zum Verteilen von elektrischer Energie für Geräte- und/oder Serverschränke. Gattungsgemäße Verteilerleisten weisen mehrere an einer Seite, beispielsweise der Oberseite, der Verteilerleiste vorgesehene Anschlusseinrichtungen auf, an welche elektrische Verbraucher zur Energieversorgung anschließbar sind. Zusätzlich sind Sensoren zum Ermitteln von Daten zu mindestens zu dem Status der Verteilerleiste und/oder den mehreren Anschlusseinrichtungen vorhanden.

Im Sinne der Erfindung kann eine Anschlusseinrichtung beispielsweise als Buchse oder Kupplung zum Verbinden mit einem Stecker angesehen werden.

Verteilerleisten dienen zum Verteilen von elektrischer Energie an elektrische oder elektronische Geräte oder Baueinheiten, welche in einem Geräte- oder Serverschrank angeordnet sind. Allgemein ausgedrückt versorgt eine Verteilerleiste elektrische Verbraucher mit Energie. Derartig versorgte Geräte oder Baueinheiten sind beispielsweise Server, Telekommunikationsgeräte, Klimageräte oder Netzwerkkomponenten wie Switches. Eine Verteilerleiste kann auch als Dosenleiste oder Power-Distribution Unit (PDU) bezeichnet werden.

In großen Rechenzentren mit 50 oder mehr Server- bzw. Komponentenschränken ist es üblich, für das Management der Energieversorgung, aber auch der weiteren Umgebung der Rechenzentren, wie beispielsweise für die Überwachung der Lufttemperatur oder dergleichen, separate Managementserver vorzusehen. Mittels dieser Managementserver werden auch Daten von gattungsgemäßen Verteilerleisten abgefragt und über das Managementsystem, welches auf dem definierten Managementserver läuft, zur Verfügung gestellt. Bei diesen Daten handelt es sich beispielsweise um die Energieaufnahme der gesamten Verteilerleiste, die Energieabgabe an jeder einzelnem Anschlusseinrichtung oder den Status, ob an einer Anschlusseinrichtung ein Verbraucher angeschlossen ist. Teilweise sind in gattungsgemäßen Verteilerleisten auch Aktorsysteme vorgesehen, mit welchen beispielsweise die Energieabgabe über bestimmte Anschlusseinrichtungen eingeschränkt oder verändert werden kann.

Nachteilig an den bekannten Managementsystemen, welche wie beschrieben auf separaten Servereinrichtungen vorgesehen sind, ist, dass diese meist für große Rechenzentren mit mehr als 50 Serverschränken ausgelegt sind. Derartige Managementsysteme sind für kleinere und mittlere Rechenzentren mit beispielsweise maximal 10 Schränken überdimensioniert und erfordern einen im Vergleich zur Funktionalität unverhältnismäßig hohen Verwaltungs- und Investitionsaufwand.

Aus der US 7,522,036 B1 ist eine Verteilerleiste bekannt, welche interne Sensoren zur Überwachung der Leistungsaufnahme von externen angeschlossenen Verbrauchern aufweist. Des Weiteren können zusätzliche externe Sensoren angeschlossen werden. Ferner ist vorgesehen, über eine Kommunikationsverbindung weitere Verteilerleisten anzuschließen und mit diesen zu kommunizieren. Die Verteilerleisten sind hierbei kaskadierend angeordnet.

Der Erfindung liegt daher die **Aufgabe** zugrunde, eine Lösung zu schaffen, mit der auch das Management von Verteilerleisten und dergleichen in kleineren und mittleren Rechenzentren ermöglicht wird, ohne jedoch hierbei den notwendigen Verwaltungs- und Konfigurationsaufwand unverhältnismäßig hoch werden zu lassen.

Die Aufgabe wird erfindungsgemäß durch eine Verteilerleiste mit den Merkmalen des Anspruchs 1 gelöst.

Bevorzugte Ausführungsformen der Erfindung sind in den abhängigen Ansprüchen und in der Figurenbeschreibung wiedergegeben.

Eine gattungsgemäße Verteilerleiste ist erfindungsgemäß dadurch weitergebildet, dass sie ein Kommunikationsmodul aufweist, welches ausgebildet ist, die Daten der Sensoren abzufragen und/oder zu empfangen sowie mit mindestens einem entfernt von der Master-Verteilerleiste angeordneten Sensor und/oder mit mindestens einem entfernt von der Master-Verteilerleiste angeordneten Aktor über ein Kommunikationsnetzwerk zu kommunizieren. Zusätzlich ist ein Informations- und Managementmodul vorgesehen, welches ausgebildet ist, die vom Kommunikationsmodul abgefragten und/oder empfangenen Daten der Sensoren über eine Kommunikationsnetzwerkschnittstelle einem Benutzer direkt zur Verfügung zu stellen. Im Folgenden wird eine derart ausgestaltete Verteilerleiste als Master-Verteilerleiste bezeichnet.

Eine Grundidee der Erfindung kann darin gesehen werden, dass auf einen separaten externen Managementserver mit entsprechender Serversoftware verzichtet werden kann, da ein Informations- und Managementmodul in der Master-Verteilerleiste integriert ist. Mit anderen Worten ist es vorgesehen, auf der Master-Verteilerleiste im Rahmen eines Embedded-Systems die Funktionalitäten eines Managementservers mit geringen Kapazitäten vorzusehen. Hierbei kann es sich beispielsweise um ausreichend Kapazitäten für ein Rechenzentrum mi-t 10 Server bzw. Komponentenschränken und ca. 20 damit verbundenen Verteilerleisten handeln, welches ca. 50 Nodes aufweist. Als Node kann hierbei beispielsweise eine Verteilerleiste, ein entfernt von einer Verteilerleiste angeordneter Sensor oder ein entfernt von einer Verteilerleiste angeordneter Aktor angesehen werden. Der Vorteil des erfindungsgemäßen Konzeptes ist es, dass somit auch für kleinere Rechenzentren eine Lösung vorhanden ist, die ein intelligentes Managementsystem anbietet, ohne dass der Betreiber eine überdimensionierte Software beschaffen muss.

Außerdem bietet sich der Vorteil, dass durch die Integration in die Master-Verteilerleiste kein zusätzlicher Server angeschafft werden muss, der in klein dimensionierten Rechenzentren zusätzlichen Platz beanspruchen würde.

Das Kommunikationsmodul kann die Daten der Sensoren entweder aktiv abfragen oder von ihnen im Rahmen eines push-Konzeptes empfangen. Selbiges gilt auch für die Kommunikation mit dem mindestens einen entfernt von der Master-Verteilerleiste angeordneten Sensor und/ dem mindestens einen entfernt von der Master-Verteilerleiste angeordneten Aktor. Diese Daten werden wiederum entweder aktiv vom Informations- und Managementmodul abgefragt oder in ähnlicher Weise über ein push-Konzept an dieses weitergeleitet. Das Informations- und Managementmodul stellt eine Kommunikationsschnittstelle für einen Benutzer zur Verfügung, hierzu sind die entsprechenden Anschlüsse an der Master-Verteilerleiste vorgesehen.

Somit ist es für einen Benutzer einfach möglich, direkt auf die Daten der Sensoren der Master-Verteilerleiste zuzugreifen, die Informationen zu sichten und/oder weiterzuverarbeiten.

Im Sinne der Erfindung kann ein entfernt von der Master-Verteilerleiste angeordneter Sensor beispielsweise ein Türkontakt, ein Temperatursensor, ein Sensor für die Umdrehungen eines Lüfters pro Zeiteinheit oder auch die Sensoren bzw. Datenschnittstellen einer USV sein. Ein entfernt von der Master-Verteilerleiste angeordneter Aktor im Sinne der Erfindung kann beispielsweise ein Türöffner, ein steuerbarer Stromkontakt oder eine USV sein. In einer vorteilhaften Weiterbildung ist das Kommunikationsmodul ferner ausgebildet, um Daten zum Status mindestens einer Standard-Verteilerleiste, welche mehrere an der Seite, beispielsweise der Oberseite, der Standard-Verteilerleiste vorgesehene Anschlusseinrichtungen aufweist, an die elektrischen Verbraucher zur Energieversorgung anschließbar sind, und/oder deren Anschlusseinrichtungen abzufragen und/oder deren Daten zu empfangen.

Diese Daten können dann dem Informations- und Managementmodul kommuniziert werden und in ähnlicher Weise wie die Daten der Master-Verteilerleiste über das Informations- und Managementmodul mittels der Kommunikationsnetzwerkschnittstelle dem Benutzer direkt zur Verfügung gestellt werden. Mit anderen Worten kann die Master-Verteilerleiste, genauer deren Kommunikationsmodul, mit weiteren im Rechenzentrum vorgesehenen Standard-Verteilerleisten, welche sich im selben Kommunikationsnetzwerk wie die Master-Verteilerleiste befinden, kommunizieren, um Daten von dieser Standard-Verteilerleiste abzufragen. Selbstverständlich kann es sich hierbei auch um mehrere Standard-Verteilerleisten handeln.

Bei der angenommenen Größe eines Rechenzentrums mit 10 Serverschränken befinden sich beispielsweise 1 Master-Verteilerleiste und 19 Standard-Verteilerleisten im Betrieb. Dies bedeutet, dass je zwei Verteilerleisten in einem Serverschrank vorgesehen sind.

Die Daten der Standard-Verteilerleisten können analog idealerweise über dieselbe Kommunikationsnetzwerkschnittstelle dem Benutzer zur Verfügung gestellt werden, wie dies auch mit den Daten der Master-Verteilerleiste selbst erfolgt.

Vorteilhaft ist es, wenn das Informations- und Managementmodul ausgebildet ist, dem Benutzer zumindest ein Webinterface für den direkten Zugriff auf die Daten der Sensoren der Master-Verteilerleiste zur Verfügung zu stellen. Zu diesem Zweck kann in das Informations- und Managementmodul ein Webserver integriert werden, über dessen Oberfläche ein einfacher und komfortabler Zugriff auf die Sensorendaten möglich ist.

Wie zuvor bereits ausgeführt, kann der Zugriff auf die Daten der Standard-Verteilerleiste beziehungsweise der mehreren Standard-Verteilerleisten in analoger Weise ebenfalls über das Webinterface erfolgen.

Ist das Informations- und Managementmodul ausgebildet, die Daten der Sensoren der Master-Verteilerleiste, der mindestens einen Standard-Verteilerleiste, von entfernt von der Master-Verteilerleiste angeordneten Sensoren und/oder von entfernt von der Master-Verteilerleiste angeordneten Aktoren über einen Zeitraum auf einem in der Master-Verteilerleiste vorgesehenen Speicher zu speichern und/oder auf einem über einen Netzwerkinterface beschreibbaren Speicher zu speichern, so können die Daten, die von dem Kommunikationsmodul beziehungsweise dem Informations- und Managementmodul erhalten und ermittelt werden, auch geloggt werden. Dies kann beispielsweise auf einem internen Speicher der Master-Verteilerleiste erfolgen. Ebenso ist es möglich, dies auf einem Netzwerkspeicher, beispielsweise im Rahmen einer Cloud-Lösung vorzusehen.

Werden die Daten auf einem externen Speicher im Rahmen einer Cloud-Lösung gespeichert, so sind verschiedene Szenarien denkbar. Zum einen kann es sich um eine private Cloud handeln, so dass der Zugriff auf diese Cloud nur über die Master-Verteilerleiste erfolgen kann. Mit anderen Worten kommuniziert der Benutzer eines derartigen Systems weiterhin direkt mit der Master-Verteilerleiste, beispielsweise deren Webinterface, wodurch das Informations- und Managementmodul veranlasst wird, die entsprechenden Daten aus der privaten Cloud zu beschaffen.

Zum anderen ist es möglich, sofern die Cloudlösung einen anderen geringeren Sicherheitsstandard erfüllen soll, ist es auch denkbar, dass es einem Benutzer ermöglicht wird, direkt auf die in der Cloud beziehungsweise den Netzwerkspeicher abgelegten Daten zuzugreifen. Hierdurch wird das Sicherheitsniveau des Gesamtsystems verringert.

Vorteilhaft ist es, wenn die Master-Verteilerleiste redundante Bauteile aufweist, um ein entsprechendes Sicherheitsniveau und eine entsprechende Ausfallsicherheit zu gewährleisten. Hierzu kann es vorgesehen sein, dass zwei Netzteile und/oder zwei Kommunikationsnetzwerkschnittstellen für das Kommunikationsmodul und das Informations- und Managementmodul vorgesehen sind. In diesem Fall kann beispielsweise, wie in Rechenzentren üblich, die Master-Verteilerleiste sowohl über Feed A als auch über Feed B versorgt werden. Selbstverständlich können auch weitere für die Master-Verteilerleiste besonders relevante Bauteile doppelt vorgesehen sein, um eine hohe Ausfallsicherheit zu gewährleisten.

In einer alternativen Konfiguration die jedoch auch fakultativ hierzu verwendet werden kann, können in einem Rechenzentrum mit mehreren Serverschränken 2 Master-Verteilerleisten simultan eingesetzt werden. In diesem Fall sind die beiden Master-Verteilerleisten derart konfiguriert, dass sie gegenseitig ihre Daten synchronisieren und so das System zumindest temporär auch bei einem Ausfall einer Master-Verteilerleiste weiterbetreiben können. Beim Einsatz in einer derartigen Konfiguration in einem Rechenzentrum sind bevorzugt mehrere Standard-Verteilerleisten vorgesehen, die in Kommunikation mit mindestens einer der beiden Master-Verteilerleisten stehen.

Ferner ist es bevorzugt, wenn das Informations- und Managementmodul eingerichtet ist, um einem Benutzer zu ermöglichen, einen Schwellwert zu zumindest einem Status der Master-Verteilerleiste, einer Standard-Verteilerleiste, eines entfernt von der Master-Verteilerleiste angeordneten Sensors und/oder eines entfernt von der Master-Verteilerleiste angeordneten Aktors festzulegen, um bei dessen Überschreitung eine definierte Aktion oder das Benachrichtigen eines Benutzers zu veranlassen. Hierbei kann es sich beispielsweise um eine Temperaturüberwachung oder Stromaufnahme handeln.

Wird eine bestimmte Temperatur an einem externen Sensor oder die Stromaufnahme einer Anschlusseinrichtung einer Standard-Verteilerleiste überschritten, so ist es beispielsweise möglich, dass ein Benutzer mittels einer E-Mail oder über einen SMS-Server von diesem Vorfall informiert wird. Gleichzeitig oder unter Berücksichtigung eines weiteren höherliegenden Schwellwertes ist es auch möglich, dass das Informations- und Kommunikationsmodul über in der entsprechenden Standard-Verteilerleiste vorgesehene Aktoren bestimmte Verbraucher abschaltet oder einen Lüfter als externen Aktor hinzuschaltet, um die Temperatur zu reduzieren.

In ähnlicher Weise können selbstverständlich auch Sensoren, die sich nicht innerhalb der Standard-Verteilerleiste befinden, abgefragt werden. So ist es beispielsweise möglich, Temperatursensoren in einem Serverschrank abzufragen und entsprechend der zuvor beschriebenen Vorgehensweise die Umdrehungszahl der Lüfter zu regeln.

Ein noch höherer Nutzen der Master-Verteilerleiste kann erreicht werden wenn das Informations- und Managementmodul eingerichtet ist, um einem Benutzer zu ermöglichen, mehrere Schwellwerte zu mehreren Stati einer Auswahl von der Master-Verteilerleiste, einer Standard-Verteilerleiste, eines entfernt von der Master-Verteilerleiste angeordneten Sensors und eines entfernt von der Master-Verteilerleiste angeordneten Aktors festzulegen, diese logisch zu verknüpfen und abhängig vom Ergebnis dieser Verknüpfung eine Nachricht an einen Benutzer zu kommunizieren und/oder eine definierte Aktion zu veranlassen. Beispielsweise ist es so möglich, die Regel zu hinterlegen, dass, wenn die Tür eines Serverschrankes geschlossen ist und die Temperatur im Inneren ansteigt, die Lüfter an der Rückseite des Serverschrankes schneller drehen sollen, jedoch nicht, wenn die Tür geöffnet ist, da gerade ein Techniker mit Arbeiten im Serverschrank beschäftigt ist, was den Temperaturanstieg erklärt, der jedoch nur temporär ist.

Das Kommunikationsmodul kann derart ausgebildet sein, dass es aktiv nach weiteren Master- und/oder Standard-Verteilerleisten und anderen Sensoren in einem Kommunikationsnetzwerk sucht, eine Verbindung zu diesen aufbaut und mit diesen kommuniziert. Eine derartige Funktionalität kann beispielsweise über das zuvor beschriebene Webinterface von einem Benutzer aktiv angestoßen werden. Anschließend kann über einen Broadcast versucht werden, eine Kommunikation mit weiteren Sensoren oder auch weiteren Verteilerleisten - seien es nun Standard- oder Master-Verteilerleisten - in demselben Kommunikationsnetzwerk oder über weitere Kommunikationsnetzwerke, die über ein Gateway erreichbar sind, aufzubauen, um auch von diesen Daten zu erhalten, welche über die Kommunikationsnetzwerkschnittstelle der Master-Verteilerleiste einem Benutzer zur Verfügung gestellt werden können.

Obwohl bereits viele Standards vorhanden sind, hat es sich als vorteilhaft erwiesen, wenn das Informations- und Managementmodul derart ausgebildet ist, die über das Kommunikationsmodul von Master- und/oder Standard-Verteilerleisten sowie von anderen Sensoren empfangenen Daten zu zumindest dem Status der Master- und/oder Standard-Verteilerleisten auf Plausibilität zu überprüfen.

Hierbei kann eine Überprüfung zum Beispiel so vorgesehen werden, dass die abgefragten und erhaltenen Daten entsprechend vorgegebener Schwellenwerte analysiert werden und Rückschlüsse auf ihre Plausibilität zulassen. Beispielsweise ist es abhängig vom Standard möglich, dass ein Komma an unterschiedlichen Stellen gesetzt wird. Dies kann durch die Plausibilitätskontrolle erkannt werden. Wird also eine Temperatur von 210,0°C empfangen, so wird es im Rahmen der Plausibilitätskontrolle erkannt, dass hierbei wohl das Komma nicht richtig gesetzt wird und die Temperatur als 21,00°C interpretiert wird. Eine derartige Funktionalität erleichtert die Konfiguration von weiteren Sensoren, seien sie nun im Rechenzentrum selbst oder in Standard-Verteilerleisten vorhanden, ohne dass weitere zusätzliche Benutzereingabe notwendig sind.

Die Erfindung wird nachfolgend anhand eines Ausführungsbeispiels und einer schematischen Zeichnung erläutert. Hierbei zeigt:

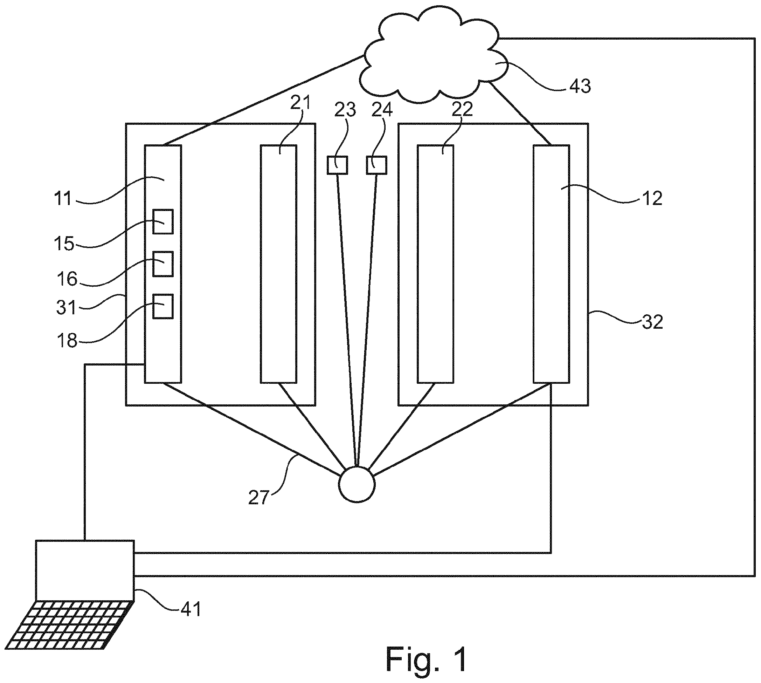

- Fig. 1: eine schematische Ansicht der wesentlichen Komponenten des erfindungsgemäßen Konzeptes in einem Rechenzentrum.

In Fig. 1 sind schematisch zwei Serverschränke 31, 32, mit je zwei Verteilerleisten 11, 12, 21, 22 dargestellt. In jedem der Serverschränke 31, 32 ist jeweils eine Master-Verteilerleiste 11, 12 und eine Standard-Verteilerleiste 21, 22 vorgesehen. Zusätzlich befinden sich in dem Serverraum exemplarisch zwei Sensoren 23, 24. Die Verteilerleisten 11, 12, 21, 22 sowie die Sensoren 23, 24 sind über ein Kommunikationsnetzwerk 27 miteinander verbunden. Zusätzlich ist exemplarisch die direkte Verbindung zwischen beiden Master-Verteilerleisten 11, 12 mit einem Rechner 41, welcher den Benutzer symbolisieren soll, dargestellt. Diese Verbindung muss nicht direkt, sondern kann über ein gängiges Netzwerk realisiert werden. In ähnlicher Weise sind die beiden Master-Verteilerleisten 11, 12 auch direkt mit einer Cloud 43 verbunden. Ebenso wie die Verbindung zu dem Rechner 41 ist es nicht zwingend notwendig, dass diese Verbindung direkt erfolgt, sondern sie kann über ein gängiges Kommunikationsnetzwerk, wie einem kabelgebundenen, optischen oder drahtlosen Kommunikationsnetzwerk sowie Kombinationen hiervon, ausgeführt sein.

Im Folgenden wird das erfindungsgemäße Konzept mit einer gattungsgemäßen Master-Verteilerleiste 11, 12 beschrieben. Die Master-Verteilerleiste 11 weist ein Kommunikationsmodul 15 und ein Informations- und Managementmodul 16 auf. Über das Kommunikationsmodul 15 baut die Master-Verteilerleiste 11 eine Verbindung zu den in der Master-Verteilerleiste 11 vorgesehenen Sensoren, beispielsweise zu vorhandenen Steckdosen, auf. Ähnlich dazu wird durch das Kommunikationsnetzwerk 27 eine Kommunikationsverbindung zu den beiden Standard-Verteilerleisten 21, 22 aufgebaut. Diese weisen zu diesem Zweck beispielsweise entweder auch ein Kommunikationsmodul oder eine direkte Verbindung über Sensoren mit dem Kommunikationsnetzwerk 27 auf. Bei dem Kommunikationsnetzwerk 27 kann es sich um ein dezidiertes Kommunikationsnetzwerk für die Master-Verteilerleiste 11 oder auch um ein allgemeines Kommunikationsnetzwerk handeln.

Analog hierzu ist das Kommunikationsnetzwerk auch mit den beiden exemplarischen externen Sensoren 23, 24 verbunden. Somit ist es dem Kommunikationsmodul über das Kommunikationsnetzwerk 27 möglich, die Daten, die zum einen in den Standard-Verteilerleisten 21, 22 und zum anderen in den Sensoren 23, 24 erfasst werden, zu erhalten. Hierfür könnten die Daten in den Sensoren 23, 24 oder den Standard-Verteilerleisten 21, 22 aktiv von dem Kommunikationsmodul 15 abgefragt werden oder auch im Rahmen eines push-Services an dieses gesendet werden. Die somit dem Kommunikationsmodul 15 vorliegenden Daten werden von diesem mit dem Informations- und Managementmodul 16 in der Master-Verteilerleiste 11 geteilt. Hier werden die Daten aufbereitet, so dass sie für einen einfachen Nutzerzugriff zur Verfügung stehen.

Beispielsweise kann dies im Rahmen eines Embedded-Webservers erfolgen. Es wird hierdurch einem Nutzer über den Rechner 41 ermöglicht, auf die Daten sowohl der Master-Verteilerleiste 11 als auch der beiden Standard-Verteilerleisten 21, 22 und der Sensoren 23, 24 zuzugreifen.

Sofern die Daten nicht nur für einen Realtime-Zugriff dienen sollen, ist es notwendig, diese über einen gewissen Zeitraum, beispielsweise einen Monat, mitloggen und abspeichern zu lassen. Hierfür ist in der Master-Verteilerleiste 11 ein interner Speicher 18 vorgesehen. Eine andere Möglichkeit besteht darin, die entsprechenden Logdaten auf einen Netzwerkspeicher im Rahmen einer Cloud-Lösung 43 abzuspeichern. In diesem Zusammenhang ist es möglich, die Cloud derart zu konfigurieren, dass ein Zugriff nur direkt über die Master-Verteilerleiste 11 möglich ist. So werden die Daten entsprechend geschützt.

In analoger Weise ist es auch möglich, einen Zugriff über den Rechner 41 durch einen Benutzer auf die Cloud 43 zuzulassen.

Um dem Benutzer einer erfindungsgemäßen Master-Verteilerleiste 11 weitere Funktionalitäten zur Verfügung zu stellen, ist es vorgesehen, dass mittels eines Interfaces in dem Informations- und Managementmodul 16 Schwellenwerte für bestimmte Sensordaten festgelegt werden, bei deren Über- oder Unterschreitung entsprechende Aktionen durchgeführt werden. So ist es beispielsweise möglich, für einen Sensor einen ersten Schwellenwert vorzusehen, bei dessen Überschreitung eine Nachricht an einen Benutzer gesendet wird. Wird ein zweiter höherliegender Schwellenwert überschritten, so ist es möglich zu definieren, dass das Informations- und Managementmodul 16 einen entsprechenden Aktor veranlasst, eine bestimmte Aktion auszuführen, die idealerweise zur Folge hat, dass der Schwellenwert wieder eingehalten wird.

Durch die Integration der zusätzlichen Intelligenz in einer erfindungsgemäßen Master-Verteilerleiste 11 stellt diese eine sicherheitsrelevante Komponente eines Rechenzentrums dar. Daher ist es bevorzugt, wenn diese mit einer entsprechenden Redundanz ausgeführt ist. Dies kann etwa durch Vorsehen jeweils doppelt ausgeführter Bauteile realisiert werden.

Eine weitere alternative oder fakultative Möglichkeit hierzu besteht darin, eine zweite Master-Verteilerleiste 12 in dem Rechenzentrum vorzusehen, welche parallel zu der ersten Master-Verteilerleiste 11 konfiguriert ist und beispielsweise im Shadow-Betrieb läuft. Die entsprechende Konfiguration und die Daten der beiden Master-Verteilerleisten 11 und 12 können dann über eine interne Funktionalität jeweils gespeichert werden, so dass sie simultan vorliegen.

Fällt eine der beiden Master-Verteilerleisten 11, 12 aus, so kann ein Betrieb des Rechenzentrums ohne Probleme mit dem Maß an Sicherheit, das durch die erfindungsgemäße Master-Verteilerleiste 11, 12 vorhanden ist, weitergeführt werden und es bleibt genügend Zeit, um die ausgefallene Master-Verteilerleiste 11, 12 zu ersetzen. Durch das erfindungsgemäße Konzept und die erfindungsgemäße Master-Verteilerleiste ist es also möglich, auch entsprechende Managementfunktionalitäten für kleinere Rechenzentren anzubieten.

## Patentansprüche

1. Master-Verteilerleiste (11, 12) zum Verteilen von elektrischer Energie für Geräte- und/oder Serverschränke (31, 32)
mit mehreren an einer Seite der Master-Verteilerleiste (11, 12) vorgesehenen Anschlusseinrichtungen, an welche elektrische Verbraucher zur Energieversorgung anschließbar sind, und
mit Sensoren zum Ermitteln von Daten zumindest zu dem Status der Master-Verteilerleiste (11, 12) und/oder der mehreren Anschlusseinrichtungen,
mit einem Kommunikationsmodul (15), welches ausgebildet ist, die Daten der Sensoren abzufragen und/oder zu empfangen und,
mit einem Informations- und Managementmodul (16), welches ausgebildet ist, die vom Kommunikationsmodul (15) abgefragten und/oder empfangenen Daten der Sensoren über eine Kommunikationsnetzwerkschnittstelle einem Benutzer direkt zur Verfügung zu stellen,
wobei das Kommunikationsmodul (15) ferner ausgebildet ist, um Daten zu dem Status mindestens einer Standard-Verteilerleiste (21, 22), welche mehrere an einer Seite der Standard-Verteilerleiste (21, 22) vorgesehenen Anschlusseinrichtungen, an die elektrische Verbraucher zur Energieversorgung anschließbar sind, aufweist, zu übermitteln und/oder deren Anschlusseinrichtungen abzufragen und/oder zu empfangen und dem Informations- und Managementmodul (16) zu kommunizieren, und
dass das Informations- und Managementmodul (16) ausgebildet ist, die Daten zu der mindestens einen Standard-Verteilerleiste (21, 22) und/oder deren Anschlusseinrichtungen über die Kommunikationsnetzwerkschnittstelle dem Benutzer direkt zur Verfügung zu stellen
**dadurch gekennzeichnet,**
**dass** das Kommunikationsmodul (15) ferner ausgebildet ist mit mindestens einem entfernt von der Master-Verteilerleiste (11, 12) angeordneten Sensor (23, 24) und/oder Aktor über ein Kommunikationsnetzwerk (27) zu kommunizieren, dass die Kommunikation des Kommunikationsmoduls (15) mit der mindestens einen Standard-Verteilerleiste (21, 22) über das Kommunikationsnetzwerk (27) durchgeführt wird, und
**dass** das Kommunikationsmodul (15) ausgebildet ist, aktiv nach Master- und/oder Standard-Verteilerleisten (21, 22) und entfernt angeordneten Sensoren (23, 24) in dem Kommunikationsnetzwerk zu suchen, eine Verbindung zu diesen aufzubauen und mit diesen zu kommunizieren.

2. Master-Verteilerleiste nach Anspruch 1,
**dadurch gekennzeichnet,**
**dass** das Informations- und Managementmodul (16) ausgebildet ist, dem Benutzer ein Webinterface für einen direkten Zugriff zumindest zu den Daten der Sensoren der Master-Verteilerleiste (11, 12) zur Verfügung zu stellen.

3. Master-Verteilerleiste nach Anspruch 2,
**dadurch gekennzeichnet,**
**dass** das Informations- und Managementmodul (16) ausgebildet ist, Daten der Sensoren der Master-Verteilerleiste (11, 12), der mindestens einen Standard-Verteilerleiste (21, 22), von entfernt von der Master-Verteilerleiste (11, 12) angeordneten Sensoren (23, 24) und/oder von entfernt von der Master-Verteilerleiste (11, 12) angeordneten Aktoren über einen Zeitraum auf einem in der Master-Verteilerleiste (11, 12) vorgesehenen Speicher (18) zu speichern und/oder auf einem über ein Netzwerkinterface beschreibbaren Speicher zu speichern.

4. Master-Verteilerleiste nach einem der Ansprüche 1 bis 3,
**dadurch gekennzeichnet,**
**dass** zwei Netzteile und/oder zwei Kommunikationsnetzwerkschnittstellen für das Kommunikationsmodul (15) und das Informations- und Managementmodul (16) vorgesehen sind.

5. Master-Verteilerleiste nach einem der Ansprüche 1 bis 4,
**dadurch gekennzeichnet,**
**dass** das Informations- und Managementmodul (16) eingerichtet ist, um einem Benutzer zu ermöglichen, einen Schwellwert zu zumindest einem Status der Master-Verteilerleiste (11, 12), einer Standard-Verteilerleiste (21, 22), eines entfernt von der Master-Verteilerleiste (11, 12) angeordneten Sensors (23, 24) und/oder eines entfernt von der Master-Verteilerleiste (11, 12) angeordneten Aktors festzulegen und bei dessen Überschreitung eine Nachricht an einen Benutzer zu kommunizieren und/oder eine definierte Aktion zu veranlassen.

6. Master-Verteilerleiste nach einem der Ansprüche 1 bis 5,
**dadurch gekennzeichnet,**
**dass** das Informations- und Managementmodul (16) eingerichtet ist, um einem Benutzer zu ermöglichen, mehrere Schwellwerte zu mehreren Stati einer Auswahl von der Master-Verteilerleiste (11, 12), einer Standard-Verteilerleiste (21, 22), eines entfernt von der Master-Verteilerleiste (11, 12) angeordneten Sensors (23, 24) und eines entfernt von der Master-Verteilerleiste (11, 12) angeordneten Aktors festzulegen, diese logisch zu verknüpfen und abhängig vom Ergebnis dieser Verknüpfung eine Nachricht an einen Benutzer zu kommunizieren und/oder eine definierte Aktion zu veranlassen.

7. Master-Verteilerleiste nach Anspruch 1,
**dadurch gekennzeichnet,**
**dass** das Informations- und Managementmodul (16) ausgebildet ist, die über das Kommunikationsmodul (15) von Master- (11, 12) und/oder Standard-Verteilerleisten (21, 22) empfangenen Daten zu zumindest dem Status der Master- (11, 12) und/oder Standard-Verteilerleisten (21, 22) auf Plausibilität zu überprüfen.

8. Rechenzentren mit mehreren Serverschränken,
**dadurch gekennzeichnet,**
**dass** mindestens zwei Master-Verteilerleisten (11, 12) nach einem der Ansprüche 1 bis 7 vorgesehen sind, und
**dass** mindestens eine Standard-Verteilerleiste (21, 22) vorgesehen ist, welche in Kommunikation mit mindestens einer der Master-Verteilerleisten (11, 12) steht.

## Claims

1. Master distributor strip (11, 12) for distributing electrical energy for equipment and/or server cabinets (31, 32),
comprising a plurality of connection means that are provided on a face of the master distributor strip (11, 12), and to which electrical loads can be connected for the purpose of energy supply, and
comprising sensors for determining data at least relating to the status of the master distributor strip (11, 12) and/or the plurality of connection means, comprising a communications module (15) which is configured to retrieve and/or receive the data of the sensors, and
comprising an information and management module (16) which is configured to provide the data of the sensors, retrieved and/or received by the communications module (15), directly to a user, via a communications network interface,
wherein the communications module (15) is furthermore configured to retrieve data relating to the status of at least one standard distributor strip (21, 22) which comprises a plurality of connection means provided on a face of the standard distributor strip (21, 22), to which connection means electrical loads can be connected for energy supply purposes, and/or to retrieve data relating to the status of the connection means of said standard distributor strip, and/or to receive the data thereof, and to communicate said data to the information and management module (16), and
wherein the information and management module (16) is configured to provide the data relating to the at least one standard distributor strip (21, 22) and/or the connection means thereof directly to the user, via the communications network interface,
**characterized in that**
the communications module (15) is furthermore configured to communicate with at least one sensor (23, 24) and/or actuator that is remote from the master distributor strip (11, 12), by means of a communications network (27),
**in that** the communication of the communications module (15) with the at least one standard distributor strip (21, 22) is conducted via the communications network (27), and
**in that** the communications module (15) is configured to actively search for master and/or standard distributor strips (21, 22) and remotely-arranged sensors (23, 24) in the communications network, to establish a connection therewith and to communicate therewith.

2. Master distributor strip according to claim 1,
**characterized in that**
the information and management module (16) is configured to provide the user with a web interface for direct access at least to the data of the sensors of the master distributor strip (11, 12).

3. Master distributor strip according to claim 2,
**characterized in that**
the information and management module (16) is configured to store data of the sensors of the master distributor strip (11, 12), the at least one standard distributor strip (21, 22), sensors (23, 24) remote from the master distributor strip (11, 12), and/or actuators remote from the master distributor strip (11, 12), for a period of time, on a memory (18) provided in the master distributor strip (11, 12), and/or to store said data on a memory that can be written via a network interface.

4. Master distributor strip according to any of claims 1 to 3,
**characterized in that**
two power packs and/or two communications network interfaces are provided for the communications module (15) and for the information and management module (16).

5. Master distributor strip according to any of claims 1 to 4,
**characterized in that**
the information and management module (16) is configured to allow a user to specify a threshold value for at least one status of the master distributor strip (11, 12), a standard distributor strip (21, 22), a sensor (23, 24) remote from the master distributor strip (11, 12), and/or an actuator remote from the master distributor strip (11, 12), in order to communicate a message to a user and/or to trigger a defined action, upon said threshold value being exceeded.

6. Master distributor strip according to any of claims 1 to 5,
**characterized in that**
the information and management module (16) is configured to allow a user to specify a plurality of threshold values for a plurality of statuses of the master distributor strip (11, 12), a standard distributor strip (21, 22), a sensor (23, 24) remote from the master distributor strip (11, 12), and an actuator remote from the master distributor strip (11, 12), to logically link said statuses, and to communicate a message to a user and/or to trigger a defined action on the basis of the result of said linking.

7. Master distributor strip according to claim 1,
**characterized in that**
the information and management module (16) is configured to check the plausibility of the data, at least relating to the status of the master (11, 12) and/or standard distributor strips (21, 22), received via the communications module (15), from the master (11, 12) and/or standard distributor strips (21, 22).

8. Data centers comprising a plurality of server cabinets,
**characterized in that**
at least two master distributor strips (11, 12) according to any of claims 1 to 7 are provided, and
**in that** at least one standard distributor strip (21, 22) is provided which communicates with at least one of the master distributor strips (11, 12).

## Revendications

1. Barre de distribution maîtresse (11,12) pour la distribution d'énergie électrique à des armoires d'appareils et/ou de serveur (31, 32)
avec des dispositifs de connexion prévus sur plusieurs côtés de la barre de distribution maîtresse (11, 12) sur lesquels des charges électriques peuvent être connectées pour être alimentées en énergie,
avec des capteurs pour déterminer des données au moins sur le statut de la barre de distribution maîtresse (11, 12) et/ou des multiples dispositifs de connexion,
avec un module de communication (15) qui est conçu pour interroger et/ou pour recevoir les données des capteurs et
avec un module d'information et de gestion (16) qui est conçu pour mettre directement à la disposition d'un utilisateur, via une interface de réseau de communication, les données des capteurs interrogées et/ou reçues par le module de communication (15),
le module de communication (15) étant en outre conçu pour transmettre les données sur le statut d'au moins une barre de distribution standard (21, 22) qui possède plusieurs dispositifs de connexion prévus sur un côté de la barre de distribution standard (21, 22) sur lesquels des charges électriques peuvent être connectées pour être alimentées en énergie, et/ou pour interroger et/ou recevoir ses dispositifs de connexion et pour les communiquer au module d'information et de gestion (16) et
le module d'information et de gestion (16) étant conçu pour mettre directement à la disposition de l'utilisateur, via une interface de réseau de communication, les données sur l'au moins une barre de distribution standard (21, 22) et/ou ses dispositifs de raccordement,
**caractérisée**
**en ce que** le module de communication (15) est en outre conçu pour communiquer, via un réseau de communication (27), avec au moins un capteur (23, 24) et/ou un actionneur installé à distance de la barre de distribution maîtresse (11, 12) et
que le module de communication (15) est conçu pour chercher activement sur le réseau de communication des capteurs (23, 24) installés en aval et à distance des barres de distribution maîtresse et standard (21, 22), pour établir une liaison avec ceux-ci et pour communiquer avec ceux-ci.

2. Barre de distribution maîtresse selon la revendication 1,
**caractérisée**
**en ce que** le module d'information et de gestion (16) est conçu pour mettre à la disposition de l'utilisateur une interface web pour accéder directement au moins aux données des capteurs de la barre de distribution maîtresse (11 12).

3. Barre de distribution maîtresse selon la revendication 2,
**caractérisée**
**en ce que** le module d'information et de gestion (16) est conçu pour mémoriser pendant une certaine durée sur une mémoire (18) prévue dans la barre de distribution maîtresse (11, 12) des données des capteurs de la barre de distribution maîtresse (11, 12), de l'au moins une barre de distribution standard (21, 22), des capteurs (23, 24) installés à distance de la barre de distribution maîtresse (11, 12) et/ou des actionneurs installés à distance de la barre de distribution maîtresse (11, 12) et/ou pour les mémoriser sur une mémoire inscriptible via une interface de réseau.

4. Barre de distribution maîtresse selon une des revendications 1 à 3,
**caractérisée**
**en ce que** deux éléments de réseau et/ou deux interfaces de réseau de communication sont prévus pour le module de communication (15) et le module d'information et de gestion (16).

5. Barre de distribution maîtresse selon une des revendications 1 à 4,
**caractérisée**
**en ce que** le module d'information et de gestion (16) est configuré pour permettre à un utilisateur de déterminer une valeur seuil pour au moins un statut de la barre de distribution maîtresse (11, 12), d'une barre de distribution standard (21, 22), d'un capteur (23, 24) installé à distance de la barre de distribution maîtresse (11, 12) et/ou d'un actionneur installé à distance de la barre de distribution maîtresse (11, 12) et pour, en cas de dépassement de cette valeur, envoyer un message à un utilisateur et/ou déclencher une action définie.

6. Barre de distribution maîtresse selon une des revendications 1 à 5,
**caractérisée**
**en ce que** le module d'information et de gestion (16) est configuré pour permettre à un utilisateur de déterminer plusieurs valeurs seuils pour plusieurs statuts d'une sélection parmi la barre de distribution maîtresse (11, 12), une barre de distribution standard (21, 22), un capteur (23, 24) installé à distance de la barre de distribution maîtresse (11, 12) et/ou un actionneur installé à distance de la barre de distribution maîtresse (11, 12), de relier ceux-ci de façon logique et, en fonction du résultat de cette relation, envoyer un message à un utilisateur et/ou déclencher une action définie.

7. Barre de distribution maîtresse selon une des revendications 1 à 6,
**caractérisée**
**en ce que** le module d'information et de gestion (16) est configuré pour vérifier la plausibilité des données reçues, via le module de communication (15) des barres de distribution maîtresse (11, 12) et/ou standard (21, 22), sur le statut des barres de distribution maîtresse (11, 12) et/ou standard (21, 22).

8. Centres de calcul possédant plusieurs armoires de serveurs,
**caractérisés**
**en ce qu'**il est prévu au moins deux barres de distribution maîtresse (11, 12) selon une des revendications 1 à 7 sont prévues et
qu'il est prévu au moins une barre de distribution standard (21, 22) qui est en communication avec au moins une des armoires de distribution maîtresses (11, 12).
